# EUROPEAN PATENT SPECIFICATION

(11) **EP 3 633 133 B1**
(45) Date of publication and mention of the grant of the patent: **28.10.2026**
(21) Application number: 18810845.0
(22) Date of filing: 15.05.2018
(51) Int. Cl.: E06B 9/28, H02S 20/20, H02S 30/00, H02S 40/22, E06B 9/386, E06B 9/24

(54) **PHOTOVOLTAIC BLIND**
PHOTOVOLTAIKJALOUSIE
STORE PHOTOVOLTAÏQUE

(30) Priority: 01.06.2017 KR 20170068213
(43) Date of publication of application: 08.04.2020
(73) Proprietor: LG Hausys, Ltd., Seoul 07326 (KR)
(72) Inventor: CHOI, Chul Jun, Seoul 07796 (KR); KIM, Jong Tae, Seoul 07796 (KR); LEE, Seung Jung, Seoul 07796 (KR)
(74) Representative: Goddar, Heinz J.
(86) International application number: PCT/KR2018/005518
(87) International publication number: WO 2018/221873

(56) References cited:
- JP-A- 2008 007 934
- JP-A- 2008 007 934
- JP-A- 2014 136 928
- KR-A- 20110 087 202
- KR-A- 20120 129 271
- KR-A- 20150 028 865
- KR-A- 20150 130 180
- KR-A- 20160 045 458
- US-A1- 2011 240 094
- US-A1- 2015 101 761

## Description

### [Technical Field]

The present invention relates to a blind for solar photovoltaic power generation. More particularly, the present invention relates to a blind for solar photovoltaic power generation including blind blades each having solar cell panels installed on one side thereof to enable solar photovoltaic power generation. In the blind of the present invention, solar cell panels are provided in a prefabricated form, allowing the solar cell panels to be replaced and repaired individually.

### [Background Art]

Recently, due to environmental pollution and depletion of fossil fuels, development of eco-friendly alternative energy sources and diversification of energy sources are emerging as international issues.

Accordingly, solar energy is attracting attention as an important alternative energy source, and interest in solar cells that convert sunlight into energy is increasing. In addition, with realization of low-cost solar cells, the scale of a global market associated with solar cells is rapidly increasing.

Along with this trend, Korean Patent No. 10-1364497 disclosing a blind for solar photovoltaic power generation that generates power using daytime sunlight was filed on April 3, 2014.

Specifically, a conventional blind blade (slat) for manufacture of a blind for solar photovoltaic power generation includes a blade frame provided with a mounting groove for mounting solar cells and provided with lead wires connected to the terminals of solar cells, a transparent reinforcement film for covering the blade frame to protect the mounted solar cells, and a wire connector for electrically connecting the lead wires and outgoing lines.

However, in the manufacture of such a conventional blind blade for solar photovoltaic power generation, in consideration of manufacturing convenience, solar cells and a transparent reinforcement film are sequentially laminated on a blade frame, and then a process of integrating the blade frame with the solar cells and the transparent reinforcement film is performed. Accordingly, when a defect occurs during manufacture or use, replacement or repair is not easy.

JP 2008/007934 A, JP 2014/136928 A and KR 2015/0130180 A disclose a blind for solar photovoltaic power generation, comprising: a fixing frame fixed to a ceiling or a window frame; and a plurality of blind blades installed under the fixing frame so as to be spaced apart from each other, wherein a plurality of solar cell panels is mounted on one surface of each of the blind blades.

US 2011/240094 A1 discloses a blind for solar photovoltaic power generation, comprising: a fixing frame fixed to a sealing or a window frame; and a plurality of blind blades installed under the fixing frame so as to be spaced apart from each other, wherein a plurality of solar cell panels is mounted on one surface of each of the blind blades, wherein the blind blade comprises a blade frame provided with a mounting groove, the solar cell panels disposed in a longitudinal direction in the mounting groove; fixing members for connecting electrodes between the solar cell panels and for fixing seams; and side covers installed at both sides of the blade frame and responsible for fixing ends of the solar cell panels.

### [Disclosure]

### [Technical Problem]

Therefore, the present invention has been made in view of the above problems, and it is one object of the present invention to provide a blind for solar photovoltaic power generation including blind blades each having solar cell panels installed on one side thereof to enable solar photovoltaic power generation. In the blind of the present invention, solar cell panels are provided in a prefabricated form, allowing the solar cell panels to be replaced and repaired individually.

### [Technical Solution]

In accordance with one aspect of the present invention, provided is a blind for solar photovoltaic power generation including a fixing frame fixed to a ceiling or a window frame; and a plurality of blind blades installed under the fixing frame so as to be spaced apart from each other, wherein a plurality of solar cell panels is mounted on one surface of each of the blind blades, wherein the blind blade comprises a blade frame provided with a mounting groove;
the solar cell panels disposed in a longitudinal direction in the mounting groove;
fixing members for connecting electrodes between the solar cell panels and for fixing seams; and
side covers installed at both sides of the blade frame and responsible for fixing ends of the solar cell panels,

wherein a top surface of each of the solar cell panels is provided with solar cells to form a condensing surface, and both sides of a bottom surface of each of the solar cell panels are provided with the back contact type (+)/(-) electrodes, wherein the blind blades are installed so as to be spaced apart from each other via lifting lines and tilting lines,
wherein a connector for electrically connecting the blind blades is installed inside the side cover;
wherein the connector comprises a connecting unit formed of a conductive material, one side of which is connected to the electrodes of the solar cell panels;
wires integrally formed at the other side of the connecting unit and electrically connected to the neighboring blind blade; and
a body formed of an insulating material for surrounding a portion where the connecting unit and the wires are connected,
wherein one side of the connecting unit is further provided with a pressurization unit formed in a bent shape so as to pressurize the electrodes of the solar cell panels and connect the electrodes.

Further embodiments are disclosed in the dependent claims.

### [Advantageous effects]

According to the present invention, a plurality of solar cell panels is installed on one side of a blind blade to enable solar photovoltaic power generation, and the solar cell panels are provided in a prefabricated form, allowing the solar cell panels to be replaced and repaired individually.

In particular, a blind according to the present invention is configured to meet the minimum specifications of a Korea micro-inverter that converts direct current generated by solar photovoltaic power generation into alternating current. The minimum specifications can be satisfied by connecting the solar cell panels in series to one blind blade and connecting the blind blades, which are installed below a fixing frame to be spaced apart from each other, in parallel.

### [Description of Drawings]

FIG. 1 illustrates a blind for solar photovoltaic power generation according to the present invention.
FIG. 2 is a perspective view showing an installation state of a blind blade according to the present invention.
FIG. 3 is a perspective view of a blind blade according to the present invention.
FIG. 4 is an exploded perspective view of a blind blade according to the present invention.
FIG. 5 illustrates an engaged state of a fixing member according to the present invention.
FIG. 6 illustrates an assembled state of a connector provided in a blind blade according to the present invention.
FIGS. 7A and 7B are perspective views of a connector according to the present invention.
FIGS. 8A and 8B are perspective views of a connector according to another embodiment of the present invention.
FIG. 9 is a perspective view showing a structure in which a connector is coupled to a blind blade according to the present invention.

### [Best mode]

Hereinafter, the functions or constructions of preferred embodiments of the present invention will now be described more fully with reference to the accompanying drawings.

Here, when reference numerals are applied to constituents illustrated in each drawing, it should be noted that like reference numerals indicate like elements throughout the specification.

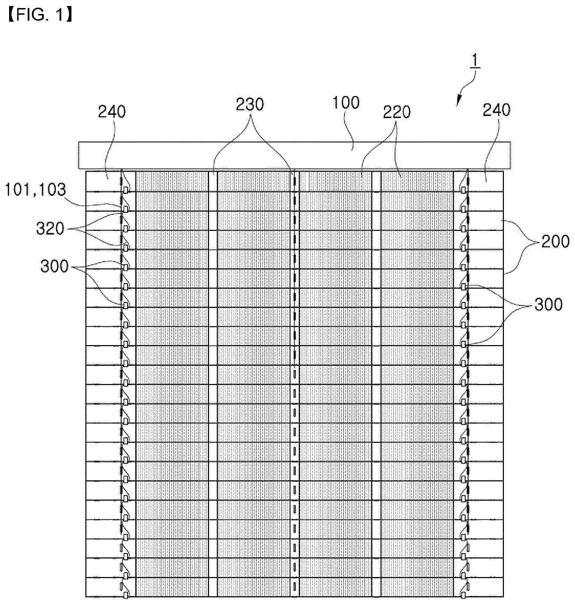

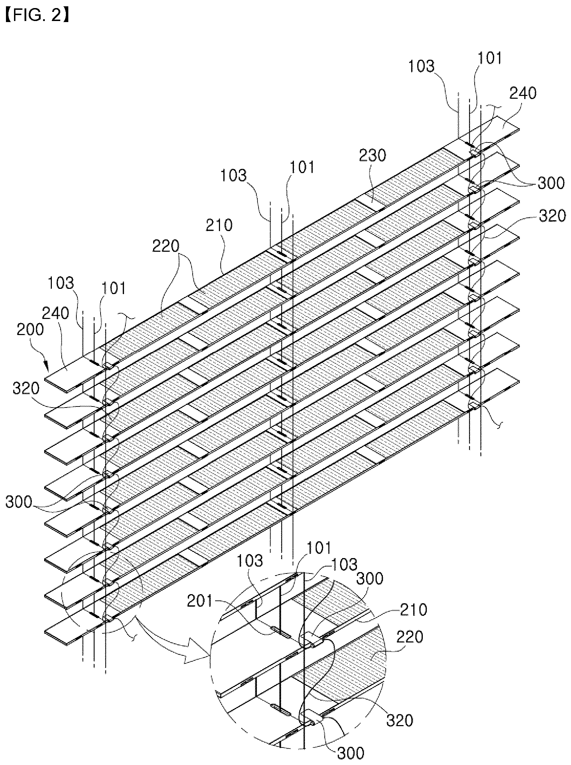

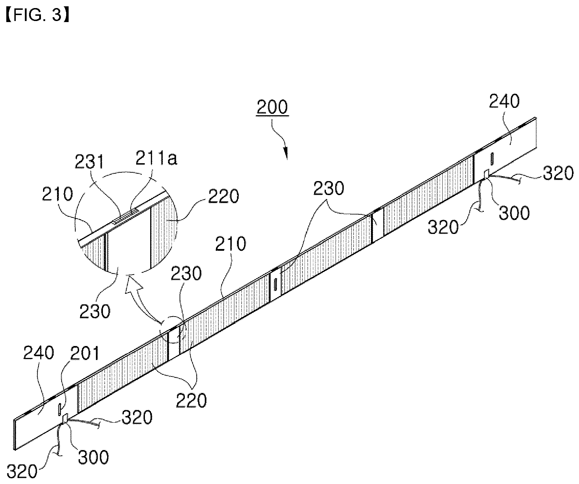

FIG. 1 illustrates a blind for solar photovoltaic power generation according to the present invention, FIG. 2 is a perspective view of a blind blade, and FIG. 3 is an exploded perspective view of a blind blade.

Referring to FIG. 1, a blind 1 for solar photovoltaic power generation according to a preferred embodiment of the present invention includes a fixing frame 100 and blind blades 200.

The configuration of the present invention is described in detail as follows.

The fixing frame 100 is installed on a ceiling or a window frame adjacent to a window. The fixing frame 100 is provided with a lifting adjusting line (not shown) for adjusting lifting of lifting lines 101 and a tilting adjusting tool (not shown) for adjusting the angle of the blind blades 200 by manipulating tilting lines 103.

For reference, the lifting adjusting line adjusts rotation of a drum (not shown) to which one end of each of the lifting lines 101 in the fixing frame 100 is fixed. As the lifting lines 101 are wound by rotation of the drum, the lowermost blind blade 200 is lifted upwards, and thus the blind blades 200 located at the upper side thereof are lifted sequentially while overlapping each other.

The tilting adjusting tool adjusts rotation of the drum in the fixing frame 100 by about half a turn clockwise or counterclockwise. According to operation of the tilting adjusting tool, either one of the tilting lines 103 formed in a ladder shape is pulled up, and thus the angles of the blind blades 200 fixed to the tilting lines 103 are adjusted.

In this case, the lifting adjusting line and the tilting adjusting tool are general components used in a blind.

Referring to FIG. 2, the blind blades 200 are installed below the fixing frame 100 so as to be spaced apart from each other. In this case, the blind blades 200 are linked to the fixing frame 100 via the lifting lines 101 and the tilting lines 103, and one surface of each of the blind blades 200 is provided with a plurality of solar cell panels 220. In this case, the lifting lines 101 are installed to penetrate through through-holes 201 formed in the longitudinal direction of the blind blade 200.

Referring to FIG. 3, the blind blade 200 includes a blade frame 210, the solar cell panels 220, fixing members 230, and side covers 240.

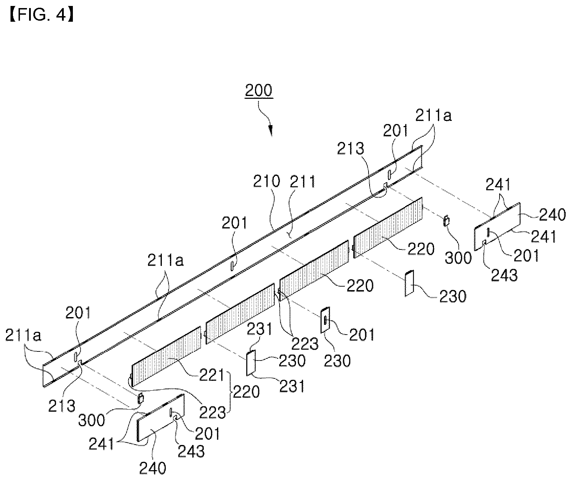

Referring to FIG. 4, the blade frame 210 constitutes the main body of the blind blade 200, and one side of the blade frame 210 is provided with a mounting groove 211 in which the solar cell panels 220 to be described later are installed. The blade frame 210 may be formed of a synthetic resin or an aluminum material. In the present invention, in consideration of durability or ease of assembly, the blade frame 210 may be formed of an aluminum material, and the present invention is described based on this case. In this case, the inner surface of the mounting groove 211 is preferably insulated through plating or film attachment.

In the mounting groove 211, the solar cell panels 220 are arranged in a row in the longitudinal direction. Specifically, the top surface of each of the solar cell panels 220 is provided with solar cells to form a condensing surface 221, and both sides of the bottom surface of each of the solar cell panels 220 are provided with back contact type (+)/(-) electrodes 223.

In this case, solar cells provided on the condensing surface 221 of the solar cell panel 220 are arranged in a direction perpendicular to the longitudinal direction of the solar cell panel 220. Accordingly, even when shade occurs in a horizontal direction on a portion of the top or bottom of the condensing surface 221 by the neighboring blind blade 200, power generation in the solar cell panels 220 is not affected. That is, since the long sides of the strip-shaped unit cells of the solar cell panel 220 are arrayed in the width direction of the blind blade 200, the entire area of the solar cells is not shaded. Accordingly, the output of the solar cell panel 220 may be reduced in accordance with the ratio of shaded areas. However, since none of solar cells connected in series are completely shaded, total output may be prevented from being significantly reduced.

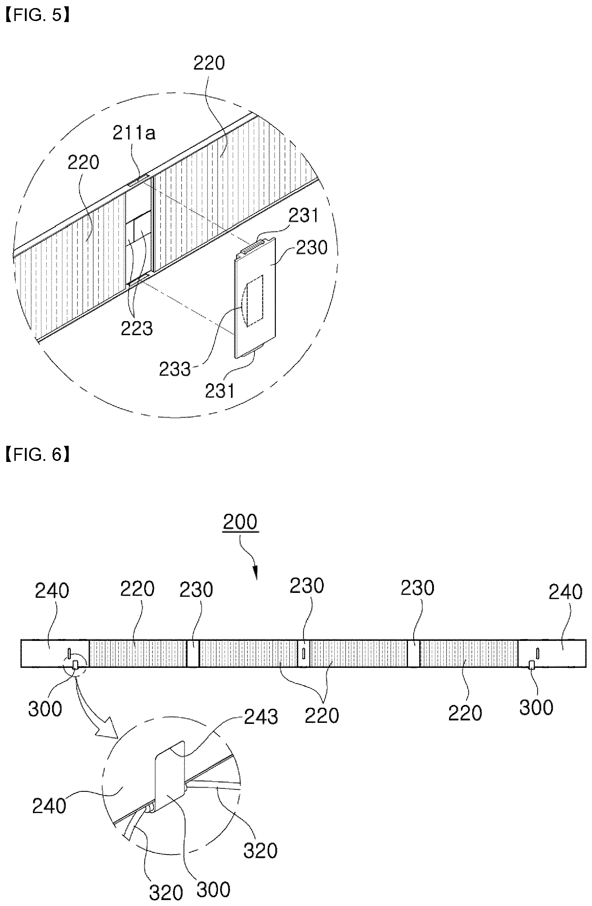

Referring to FIG. 5, the fixing members 230 serve to connect the electrodes 223 between the solar cell panels 220 continuously disposed in the mounting groove 211. In addition, the fixing members 230 serve to fix the positions of the solar cell panels 220.

Specifically, each of the fixing members 230 is provided with fitting protrusions 231 corresponding to fitting holes 211a provided at both sides of the mounting groove 211 of the blade frame 210 so that the fitting protrusions 231 are fitted into the fitting holes 211a and the fixing member 230 is coupled to the blade frame 210. The fixing members 230 may be formed of a synthetic resin.

In this case, an inclined surface is formed at the tip of each of the fitting protrusions 231, and the fitting holes 211a are formed in sidewalls formed by bending both sides of the blade frame 210 formed of an aluminum material. Accordingly, the fitting protrusions 231 of the fixing member 230 may be elastically fitted to the fitting holes 211a. However, the present invention is not limited to this coupling method, and the fitting protrusions 231 of the fixing members 230 may be configured according to a snap-fit coupling method.

In addition, a pressurization protrusion 233 may be formed on one surface of the fixing member 230 so that the pressurization protrusion 233 protrudes therefrom. When the fixing member 230 is coupled to the blade frame 210, the pressurization protrusion 233 pressurizes a connection point of the electrodes 223 between the solar cell panels 220 to connect the electrodes 223.

That is, for convenience of assembly, the solar cell panels 220 are disposed so that the connection parts of the electrodes 223 overlap each other, and the overlapping connection parts of the electrodes 223 are connected to each other by pressurization of the pressurization protrusion 233 during assembly of the fixing members 230. Accordingly, instead of fixing the electrodes 223 between the solar cell panels 220 by soldering, the electrodes 223 may be connected to each other simply by assembling the fixing members 230.

Referring to FIG. 4, the side covers 240 are installed at both sides of the blade frame 210 to fix the ends of the solar cell panels 220 disposed on both sides of the mounting groove 211. Specifically, the side covers 240 are provided with fitting protrusions 241 corresponding to the fitting holes 211a disposed at both sides of the mounting groove 211 of the blade frame 210 so that the fitting protrusions 241 are fitted into the fitting holes 211a and the side covers 240 are coupled to the blade frame 210. The side covers 240 may be formed of a synthetic resin.

Referring to FIG. 6, connectors 300 for electrically connecting the blind blades 200 are provided inside the side covers 240.

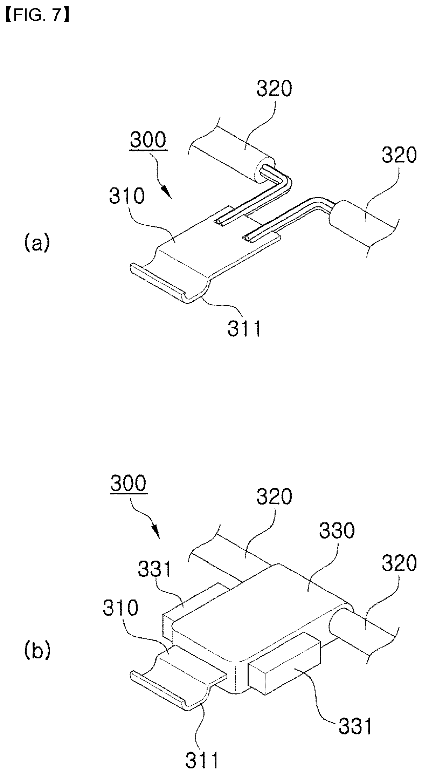

Referring to FIG. 7, each of the connectors 300 includes a connecting unit 310 formed of a conductive material, one side of which is connected to the electrodes 223 of the solar cell panels 220; wires 320 integrally formed at the other side of the connecting unit 310 and electrically connected to the neighboring blind blade 200; and a body 330 formed of an insulating material for surrounding a portion where the connecting unit 310 and the wires 320 are connected.

In this case, a pressurization unit 311 is provided at one side of the connecting unit 310 so as to pressurize the top surfaces of the electrodes 223 of the solar cell panels 220 and connect the electrodes 223 during assembly of the connector 300. The pressurization unit 311 may be formed in a semicircular shape bent downward. That is, the connectors 300 may be easily connected to the electrodes 223 of the solar cell panels 220 through configuration of the pressurization unit 311 instead of being connected to the electrodes 223 of the solar cell panels 220 through separate soldering.

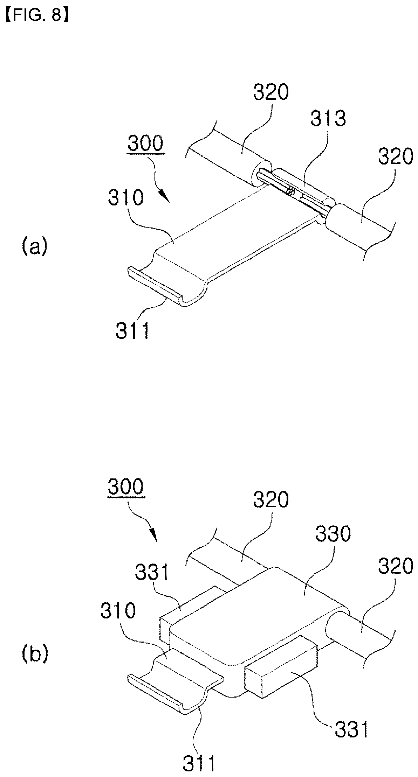

In addition, the wires 320 may be integrally formed on the other side of the connecting unit 310 by soldering. In another embodiment, as shown in FIG. 8, the wires 320 may be fitted into a ring 313 formed in a bent shape on the other side of the connecting unit 310, and then the ring 313 may be pressed to fix the wires 320.

In addition, the body 330 prevents water or moisture from entering a portion where the connecting unit 310 and the wires 320 are connected, and may be formed integrally by insert injection molding.

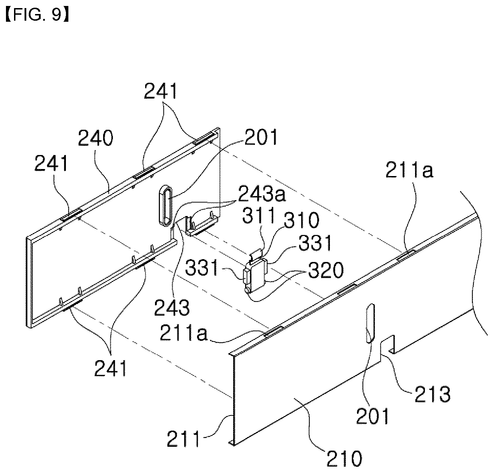

Referring to FIG. 9, installation grooves 213 and 243 are respectively formed in the blade frame 210 and each of the side covers 240 coupled to the blade frame 210 so that the connector 300 is installed between the blade frame 210 and the side cover 240 during assembly of the side cover 240. Specifically, mounting protrusions 331 are formed on both sides of the body 330, coupling grooves 243a are formed in the installation groove 243 of the side cover 240, and the mounting protrusions 331 are mounted in the coupling grooves 243a, thereby preventing the body 330 from shaking.

In the blind 1 for solar photovoltaic power generation according to the present invention described above, the solar cell panels 220 are continuously installed on one side of the blind blade 200 to enable solar photovoltaic power generation. In this case, the solar cell panels 220 are provided in a prefabricated form, allowing the solar cell panels 220 to be replaced and repaired individually.

In particular, the blind 1 according to the present invention is configured to meet the minimum specifications of a Korea micro-inverter that converts direct current generated by solar photovoltaic power generation into alternating current. The minimum specifications may be satisfied by connecting the solar cell panels 220 in series to one blind blade 200 and connecting the blind blades 200, which are installed below the fixing frame 100 to be spaced apart from each other, in parallel.

For example, in the blind 1 according to the present invention, four solar cell panels 220 are connected in series to one blind blade 200, and 35 blind blades 200 are connected in parallel. In addition, by connecting two sets of the blind 1 in parallel, the current specifications (20 to 50 Vdc and 12 A) of a Korea micro-inverter may be satisfied. However, the present invention is not limited thereto, and various modifications may be made to meet the minimum specifications of an inverter applied to the blind 1 for solar photovoltaic power generation.

### [Description of Symbols]

| | | | |
|---|---|---|---|
| 1: | BLIND FOR SOLAR PHOTOVOLTAIC POWER GENERATION | | |
| 100: | FIXING FRAME | | |
| 101: | LIFTING LINES | 103: | TILTING LINES |
| 200: | BLIND BLADES | 201: | THROUGH-HOLES |
| 210: | BLADE FRAME | 211: | MOUNTING GROOVE |
| 211a: | FITTING HOLES | 213: | INSTALLATION GROOVE |
| 220: | SOLAR CELL PANELS | 221: | CONDENSING SURFACE |
| 223: | ELECTRODES | 230: | FIXING MEMBERS |
| 231: | FITTING PROTRUSIONS | 233: | PRESSURIZATION PROTRUSION |
| 240: | SIDE COVERS | 241: | FITTING PROTRUSIONS |

## Claims

1. A blind for solar photovoltaic power generation, comprising:
a fixing frame (100) fixed to a ceiling or a window frame;
a plurality of blind blades (200) installed under the fixing frame (100) so as to be spaced apart from each other, wherein a plurality of solar cell panels (220) is mounted on one surface of each of the blind blades (200);
wherein the blind blade (200) comprises a blade frame (210) provided with a mounting groove (211);
the solar cell panels (220) disposed in a longitudinal direction in the mounting groove (211);
fixing members (230) for connecting electrodes (223) between the solar cell panels (220) and for fixing seams;
side covers (240) installed at both sides of the blade frame (210) and responsible for fixing ends of the solar cell panels (220);
wherein a top surface of each of the solar cell panels (220) is provided with solar cells to form a condensing surface (221), and both sides of a bottom surface of each of the solar cell panels (220) are provided with the back contact type (+)/(-) electrodes (223);
wherein the blind blades (200) are installed so as to be spaced apart from each other via lifting lines (101) and tilting lines (103);
wherein a connector (300) for electrically connecting the blind blades (200) is installed inside the side cover (240);
wherein the connector (300) comprises a connecting unit (310) formed of a conductive material, one side of which is connected to the electrodes (223) of the solar cell panels (220);
wires (320) integrally formed at the other side of the connecting unit (310) and electrically connected to the neighboring blind blade (200); and
a body (330) formed of an insulating material for surrounding a portion where the connecting unit (310) and the wires (320) are connected,
wherein one side of the connecting unit (310) is further provided with a pressurization unit (311) formed in a bent shape so as to pressurize the electrodes (223) of the solar cell panels (220) and connect the electrodes (223).

2. The blind according to claim 1, wherein each of the fixing members (230) is provided with fitting protrusions (231) configured to be fitted into fitting holes (211a) provided at both sides of the mounting groove (211).

3. The blind according to claim 2, wherein one side of the fixing member (230) is further provided with a pressurization protrusion (233) for pressurizing a connection point of the electrodes (223) between the solar cell panels (220) to connect the electrodes (223).

4. The blind according to claim 1, wherein each of the side covers (240) is provided with fitting protrusions (241) configured to be fitted into fitting holes (211a) provided at both sides of the mounting groove (211).

## Patentansprüche

1. Jalousie zur photovoltaischen Solarstromerzeugung, umfassend:
einen Befestigungsrahmen (100), der an einer Decke oder einem Fensterrahmen befestigt ist;
eine Vielzahl von Jalousielamellen (200), die unter dem Befestigungsrahmen (100) so installiert sind, dass sie voneinander beabstandet sind, wobei eine Vielzahl von Solarzellenplatten (220) auf einer Oberfläche jeder der Jalousielamellen (200) montiert ist;
wobei die Jalousielamelle (200) einen Lamellenrahmen (210) umfasst, der mit einer Montagenut (211) versehen ist;
wobei die Solarzellenplatten (220) in einer Längsrichtung in der Montagenut (211) angeordnet sind;
Befestigungselemente (230) zum Verbinden von Elektroden (223) zwischen den Solarzellenplatten (220) und zum Befestigen von Nähten;
Seitenabdeckungen (240), die an beiden Seiten des Lamellenrahmens (210) installiert sind und für das Befestigen von Enden der Solarzellenplatten (220) verantwortlich sind;
wobei eine obere Oberfläche jeder der Solarzellenplatten (220) mit Solarzellen versehen ist, um eine kondensierende Oberfläche (221) zu bilden, und beide Seiten einer unteren Oberfläche jeder der Solarzellenplatten (220) mit den (+)/(-) Elektroden vom Rückkontakttyp (223) versehen sind;
wobei die Jalousielamellen (200) so installiert sind, dass sie über Hebelinien (101) und Kipplinien (103) voneinander beabstandet sind;
wobei ein Verbinder (300) zum elektrischen Verbinden der Jalousielamellen (200) innerhalb der Seitenabdeckung (240) installiert ist;
wobei der Verbinder (300) eine Verbindungseinheit (310) umfasst, die aus einem leitfähigen Material gebildet ist, wobei eine Seite davon mit den Elektroden (223) der Solarzellenplatten (220) verbunden ist;
Drähte (320), die integral an der anderen Seite der Verbindungseinheit (310) gebildet sind und elektrisch mit der benachbarten Jalousielamelle (200) verbunden sind; und
einen Körper (330), der aus einem isolierenden Material gebildet ist, um einen Abschnitt zu umgeben, wo die Verbindungseinheit (310) und die Drähte (320) verbunden sind,
wobei eine Seite der Verbindungseinheit (310) ferner mit einer Druckbeaufschlagungseinheit (311) versehen ist, die in einer gebogenen Form gebildet ist, um die Elektroden (223) der Solarzellenplatten (220) mit Druck zu beaufschlagen und die Elektroden (223) zu verbinden.

2. Jalousie nach Anspruch 1, wobei jedes der Befestigungselemente (230) mit Passvorsprüngen (231) versehen ist, die konfiguriert sind, um in Passlöcher (211a) eingepasst zu werden, die an beiden Seiten der Montagenut (211) vorgesehen sind.

3. Jalousie nach Anspruch 2, wobei eine Seite des Befestigungselements (230) ferner mit einem Druckbeaufschlagungsvorsprung (233) versehen ist, um einen Verbindungspunkt der Elektroden (223) zwischen den Solarzellenplatten (220) mit Druck zu beaufschlagen, um die Elektroden (223) zu verbinden.

4. Jalousie nach Anspruch 1, wobei jede der Seitenabdeckungen (240) mit Passvorsprüngen (241) versehen ist, die konfiguriert sind, um in Passlöcher (211a) eingepasst zu werden, die an beiden Seiten der Montagenut (211) vorgesehen sind.

## Revendications

1. Store pour production d'énergie solaire photovoltaïque, comprenant :
un bâti de fixation (100) fixé à un plafond ou un dormant de fenêtre ;
une pluralité de lames de store (200) installées sous le bâti de fixation (100) de façon à être espacées l'une de l'autre, une pluralité de panneaux de cellules solaires (220) étant montés sur une surface de chacune des lames de store (200) ;
la lame de store (200) comprenant un cadre de lame (210) agencé avec une gorge de montage (211) ;
les panneaux de cellules solaires (220) disposés dans le sens longitudinal dans la gorge de montage (211) ;
des éléments de fixation (230) pour connecter des électrodes (223) entre les panneaux de cellules solaires (220) et pour la fixation des joints ;
des panneaux latéraux (240) installés des deux côtés du cadre de lame (210) et chargés de fixer les bouts des panneaux de cellules solaires (220) ;
une surface supérieure de chacun des panneaux de cellules solaires (220) étant agencée avec des cellules solaires pour constituer une surface de condensation (221), et les deux côtés d'une surface inférieure de chacun des panneaux de cellules solaires (220) étant agencés avec les électrodes (223) de contact arrière (+)/(-) ;
les lames de store (200) étant installées de façon à être espacées l'une de l'autre par le biais de lignes de levage (101) et de lignes de bascule (103) ;
un connecteur (300) pour la connexion électrique des lames de store (200) étant installé à l'intérieur du panneau latéral (240) ;
le connecteur (300) comprenant un dispositif de connexion (310) constitué d'une matière conductrice, un côté duquel étant connecté aux électrodes (223) des panneaux de cellules solaires (220) ;
des fils (320) formés de façon intégrante sur l'autre côté du dispositif de connexion (310) et connectés électriquement à la lame de store (200) avoisinante ; et
un corps (330) composé d'une matière isolante pour entourer une partie où le dispositif de connexion (310) et les fils (320) sont connectés,
un côté du dispositif de connexion (310) étant agencé en outre avec un dispositif de pressurisation (311) réalisé avec une forme courbée de façon à pressuriser les électrodes (223) des panneaux de cellules solaires (220) et connecter les électrodes (223).

2. Store selon la revendication 1, chacun des éléments de fixation (230) étant doté de saillies d'assemblage (231) configurées pour être montées dans des trous d'assemblage (211a) agencés des deux côtés de la gorge de montage (211).

3. Store selon la revendication 2, un côté de l'élément de fixation (230) étant doté en outre d'une saillie de pressurisation (233) pour la mise sous pression d'un point de connexion des électrodes (223) entre les panneaux de cellules solaires (220) pour connecter les électrodes (223).

4. Store selon la revendication 1, chacun des panneaux latéraux (240) étant muni de saillies d'assemblage (241) configurées pour être montées dans des orifices d'assemblage (211a) agencés des deux côtés de la gorge de montage (211).
